# EUROPEAN PATENT APPLICATION

(11) **EP 4 344 364 A1**
(43) Date of publication of application: **27.03.2024**
(21) Application number: 22197517.0
(22) Date of filing: 23.09.2022
(51) Int. Cl.: H05K 3/12, H01L 21/67, H05K 3/22

(54) **THERMAL PROCESSING DEVICE AND METHOD**

(71) Applicant: Nederlandse Organisatie voor toegepast-natuurwetenschappelijk Onderzoek TNO, 2595 DA 's-Gravenhage (NL)
(72) Inventor: HENDRIKS, Rob Jacob, 2595 DA 's-Gravenhage (NL); BRUNING, Fabien Bernard Jacques, 2595 DA 's-Gravenhage (NL)
(74) Representative: V.O.

(57) **Abstract**

A thermal processing device (1) is disclosed herein for thermally processing material (MTR) on a substrate (STR). The thermal processing device comprises a support plate (10) which at a first main side (11) is provided with a layer stack (12) having a free surface (13) for supporting the substrate, wherein the free surface defines a reference plane (x,y) and which layer stack (12) includes a first resistive heating layer (121), a second resistive heating layer (122), and an electrical insulator layer (123) between said first resistive heating layer (121) and said second resistive heating layer (122). The resistive heating layer (121) each comprise a respective plurality of mutually electrically insulated resistive heating strips (121_1, 121_2, ..., 121_n, ...,121_N) that extend in a mutually different directions.

## Description

The present invention pertains to a thermal processing device for thermal processing structures, such as electronic and/or optical structures on a substrate.

The present invention further pertains to a method of thermal processing structures on a substrate.

### BACKGROUND

In the field of printed functional structures, such as printed electronics, functional components and interconnections are printed on a substrate. Various printing methods are suitable for this purpose, such as screen printing, flexography, gravure, offset lithography, and inkjet. Electrically functional electronic or optical inks are deposited on the substrate, in order to form active or passive devices, such as thin film transistors; capacitors; coils; resistors. The functional ink may comprise a solution or a dispersion of a functional material. Alternatively or additionally the functional ink may comprise polymerizable components. Exemplary materials used in the filed of printed electronics are described in https://en.wikipedia.org/wiki/Printed_electronics#:~:text=Printed%20electronics% 20is%20a%20set, %2C%20offset%20lithography%2C%20and%20inkjet.

In the field of printed functional structures, the majority of inks need to be thermally cured after deposition. Typically conductive inks and dielectric inks need to be cured at around 120 - 150C for 10 to 20 minutes in a convection oven. As convective heating is slow, the throughput and efficiency is limited. There is a need for means that render possible a more time-efficient thermal processing.

### SUMMARY

In order to address the above-mentioned need, an improved thermal processing device for thermally processing printed functional structures, such as electronic and/or optical structures on a substrate is provided.

In order to address the above-mentioned need, also an improved thermal processing method for thermally processing printed functional structures, such as electronic and/or optical structures on a substrate is provided.

The improved thermal processing device comprises a support plate which at a first main side is provided with a layer stack having a free surface for supporting the substrate with the printed functional structures. The free surface defines a reference plane and the layer stack includes a first resistive heating layer, a second resistive heating layer, and an electrical insulator layer between the first resistive heating layer and the second resistive heating layer.

The first resistive heating layer comprises a first plurality of mutually electrically insulated resistive heating strips that extend in a direction of a first axis in the reference plane. The second resistive heating layer comprises a second plurality of mutually electrically insulated resistive heating strips that extend in a direction of a second axis in the reference plane differing from said first axis, for example transverse to the reference axis or preferably orthogonal to the first axis.

Each of the resistive heating strips of the first plurality and each of the resistive heating strips of the second plurality is configured to be driven by a respective electric power source.

The improved thermal processing device with this configuration of first and second heating strips each being configured to be driven by a respective electric power source renders it possible to cure the printed substances in the substrate in a time-efficient and well controlled manner. The free surface of the stack can be rapidly heated, while the independently driven resistive strips allow for an accurate control of the temperature distribution over the surface.

In an embodiment, the resistive heating strips of the first plurality each have a respective first end portion with a respective first electric contact and a respective second end portion with a respective second electric contact opposite said first end portion. Likewise, the resistive heating strips of the second plurality each have a respective further first end portion with a respective further first electric contact and a respective further second end portion with a respective second further electric contact opposite said further first end portion.

In an example of this embodiment the electric contacts of the resistive heating strips extend laterally outside the stack for connection to an electric power source.

In another example of this embodiment, the support plate comprises at a second main side, opposite the first main side at each first end portion and at each second end of each heating strip of the first plurality a respective first recess and a respective second recess that tapers inward in a direction towards a respective opening at the first main side of the support plate. In this example, the respective first electric contact at the respective first end and the respective second electric contact at the respective second end is formed by a respective electrically conductive layer that is provided on the support plate in the respective first recess and the respective second recess and these electric contacts are electrically connected with the respective first end portion and the respective second end portion respectively through the respective openings. The support plate at the second main side further comprises at each further first end portion and at each further second end portion of each heating strip of the second plurality a respective further first recess and a respective further second recess that tapers inward in a direction towards a respective opening at the first main side of the support plate. The respective further first electric contact at the respective further first end and the respective further second electric contact at the respective further second end are formed by a respective electrically conductive layer that is provided on the support plate in the respective first recess and the respective second recess. The respective further first electric contact and second electric contact are electrically connected respectively with the respective further first end portion and the respective further second end portion through said respective openings. In this later example the electric contacts of the resistive heating strips can be efficiently connected by arranging the support plate on a carrier with respective electric contact pins (such as pogo pins) that cooperate with the respective electric contacts.

In an embodiment, the thermal processing device further comprises a power supply with a respective power supply unit for each heating strip of the first plurality and for each heating strip of the second plurality. Each power supply unit comprises an electric power source section and a power controller to minimize a difference between an electric power provided by the respective power supply unit and an electric power estimated to achieve a predetermined desired temperature value.

In case of a series production of printed structures it suffices to estimate the required electric power by a single calibration of simulation step. The estimated values can be stored and each time the power controller can control the power supplied to the heating strips in accordance with these stored values. In an example of this embodiment the power controller comprises a temperature estimation section to provide an estimation of an operational temperature of a resistive heating strip and a feedback control section to minimize a difference between an operational temperature indicated by the estimation and a predetermined desired temperature value. In this embodiment it is not necessary to rely on stored power settings. Therewith the thermal processing device can adjust the power settings easily for mutually different structures. Alternatively the power controller may estimate the required power setting on the basis of a predetermined stored power setting and adjust the stored power setting on the basis of the output from the temperature estimation section. In an example, the temperature estimation section is configured to measure an electrical resistance of the resistive heating strip and computes an estimated value of the operational temperature on the basis of the measured electrical resistance and the temperature coefficient of resistance of the resistive heating strip. Therewith a separate temperature sensor is not necessary.

In an embodiment a thermal processing device comprising a temperature estimation section as described above is operable in an operational mode selected from a calibration mode and a power controlled functional mode. The thermal processing device operable in the calibration mode is configured to perform a calibration wherein it estimates a relationship between a supplied electric power by each of the power supply units as a function of time and a temperature distribution as a function of time. The thermal processing device operable in the power controlled functional mode controls an electric power supplied by each of the power supply units as a function of time to approximate a desired temperature distribution as a function of time based on the estimated relationship.

In an embodiment a thermal processing device comprising a temperature estimation section as described above, which is operable in a temperature controlled functional mode controls a supplied power to each resistive heating strip to minimize a difference between an operational temperature of said each heating strip indicated by the estimation and a predetermined desired temperature value as a function of time.

In these embodiments the thermal processing device can control the temperature in accordance with a predetermined user defined temperature profile. Therein the user can specify a rate at which the substrate with the electronic and/or optical structures is heated, a predetermined time interval wherein the substrate is maintained at a predetermined temperature and optionally a rate with which the substrate is cooled down subsequent to that that interval.

An embodiment of the thermal processing device may comprise a feedback control section with a PWM-controller to provide a PWM-control signal to switch the electric power source section in the temperature controlled functional mode. The PWM-controller is configured to periodically start a PWM-cycle in accordance with a clock signal and to end each PWM-cycle each time that the operational temperature of the heating strip controlled therewith as indicated by the estimation tends to exceed the predetermined desired temperature value. In this way an electric power is delivered to the heating strip at a fixed frequency and with a variable pulse duration.

To avoid spatial temperature differences, the operation of the respective PWM-controllers of the heating strips maybe synchronized, that is the PWM-controllers use the same clock signal to start their PWM-cycle. However synchronization is not necessary if the clock signals of the PWM-controllers have a sufficiently high clock frequency, e.g. at least 10 Hz. In practical embodiments the PWM-controllers use the same clock signal, regardless the frequency thereof, as this reduces material costs. For example the PWM-controllers may use a common clock signal with a frequency of 100 Hz or higher. In some embodiments the respective PWM-controllers of the heating strips are synchronized to a common clock generator, but with respective, mutually different delays. Therewith it is a achieved that a variations in a load imposed to a power supply are mitigated in that it is avoided that all heating strips are simultaneously activated.

In an alternative embodiment the controller is configured to start a heating-cycle if the estimated operational temperature of the heating strip is less than a first threshold temperature value and end each heating-cycle each time that the estimated operational temperature of the heating strip exceeds a second threshold temperature value greater than the first threshold temperature value. In this case temperature variations can be restricted to a predetermined temperature range specified by the first and the second threshold temperature. These can be specified as function of time. Due to the fact that the respective controllers operate independently from each other, also in this case a substantial mitigation of variations in the load to the power supply can be achieved.

In some embodiment the thermal processing device further comprises a cooling unit and an actuator. The cooling unit has a cooling surface at a side facing the second side of the support plate. The actuator is configured to position the cooling unit with its cooling surface at a distance from the support plate in a first functional mode wherein the power supply is activated to provide the controlled electric power and the actuator is configured to position the cooling unit with its cooling surface in thermal contact with the support plate in a second functional mode in order to rapidly cool down the plate. In this embodiment an even more time efficient processing is possible in that the substrate with the printed structures thereon can be rapidly cooled once the structures a cured, so that subsequent structures may be printed, or the substrate with the printed structures can be released. In an example of this second functional mode, the cooling rate is moderated by heating the plate with the resistive heating layers. Therewith thermal shock effects may be avoided. The cooling rate can be user specified in a temperature profile.

In an example, the thermal processing device comprising the cooling unit also comprising a housing with a bottom wall and a round going wall extending from the bottom wall. In this example, the support plate is carried by a side of the round going wall opposite the bottom wall, and the cooling unit and the actuator are arranged in a space enclosed by the bottom wall, the round going wall and the plate. In this example, the plate is provided with evacuation openings that extend through the support plate and the cooling unit comprises respective evacuation channels that extend from the cooling surface to communicate with the space enclosed in housing. The respective evacuation channels are arranged opposite the evacuation openings to allow application of a vacuum at the first main side by communication with an evacuated space at the second main side through the evacuation openings in the support plate and the evacuation channels. The evacuation openings are for example provided at positions between a pair of subsequent resistive heating strips of said first plurality and a pair of subsequent resistive heating strips of said second plurality. The support plate may comprise one or more compensation heating strips at a periphery supported by the round going wall of the housing to compensate for a heat flow occurring at the periphery of the plate towards the round going wall of the housing. The compensation heating strips can each have a respective controlled power supply.

In an embodiment of the thermal processing device the layer stack comprises an additional electrical insulator layer between its first main side and the first resistive heating layer. Therewith the thermal processing device can also be provided with a support plate of an electrically non-insulating material. In an example thereof, the support plate is a 1-0-0 oriented silicon wafer. This material is very suitable as it allows the support plate to be manufactured with a minimum of steps.

In an embodiment of the thermal processing device the layer stack at a side facing away from the support plate comprises an anti-stick layer. Should incidentally melting of the substrate occur during thermal processing, the substrate can still be easily released from the anti-stick layer.

An improved method of thermal processing structures on a substrate comprises the following steps:
a) providing a support plate at a first main side with a layer stack having a free surface for supporting the substrate, wherein the free surface defines a reference plane. Providing the layer stack includes the subsequent steps:
   a1) providing a first resistive heating layer having a first plurality of mutually electrically insulated resistive heating strips extending in a direction of a first axis in the reference plane.
   a2) providing an electrical insulator layer.
   a3) providing a second resistive heating layer having a second plurality of mutually electrically insulated resistive heating strips extending in a direction of a second axis in the reference plane differing from said first axis, typically orthogonal to the first axis.
b) supplying a respective controlled electric power to each of the resistive heating strips of the first plurality and of the second plurality for heating the substrate with a controlled spatial distribution over the area of the free surface.

An embodiment of the method comprises for each resistive heating strip of the first plurality and the second plurality providing a respective temperature indicator, indicating an estimated average temperature of said each resistive heating strip and controlling the respective electric power source of each of the resistive heating strips to minimize a difference between the electric power provided to said each resistive heating strip and an electric power which is estimated to achieve a predetermined desired temperature value. In an example of this embodiment a respective controlled electric power is provided to each heating strip in a pulse width controlled manner, wherein each PWM cycle is initiated by a clock signal, and is ended when the respective temperature indicator of the each heating strip indicates that its estimated average temperature tends to exceed the predetermined desired temperature value.

An embodiment of the improved method comprises measuring an electric resistance of each heating strip and computing the respective temperature indicator for each heating strip on the basis of the measured electrical resistance and the temperature coefficient of resistance of said each resistive heating strip.

In an embodiment the improved method subsequently comprising operating in a calibration mode a) and in a power controlled functional mode b). Operating in the calibration mode a) comprises:
a1) In the absence of a substrate on the free surface, individually supplying a controlled electric power to achieve that each of the respective temperature indicators of the resistive heating strips indicates at a point in time that a situation is achieved wherein the temperature has a predetermined value and the temperature at that point in time increases with a predetermine rate. As an example the predetermined value for the temperature is 150 C and the predetermine rate of increase is 100 C/s.
a2) determining a first magnitude of the electric power supplied to each of the heating strips with which this situation is achieved.
a3) determining a second respective magnitude of the electric power supplied by each respective pair of a resistive heating strips of the first plurality and a heating strip of the second plurality.
a4) determining a first total electric power magnitude, being the sum of the first magnitudes. For example in the above mentioned case it is determined that the first total electric power magnitude is 920 W.
a5) placing a substrate on the free surface of the layer stack.
a6) with the substrate placed on the free surface, individually supplying a controlled electric power to achieve that each of the respective temperature indicators of the resistive heating strips indicates at a point in time that said situation is achieved wherein the temperature has the predetermined value and increases with the predetermine rate as specified for step a1). Hence in this example the predetermined value for the temperature is 150 C and the predetermine rate of increase is 100 C/s.
a7) determining a third respective magnitude of the electric power supplied to each of the heating strips with which this situation is achieved.
a8) determining a fourth respective magnitude of the electric power supplied by each respective pair of a resistive heating strips of the first plurality and a heating strip of the second plurality.
a9) determining a second total electric power magnitude being the sum of the first magnitudes. For example it is determined that the second total electric power magnitude is 1140 W.
a10) determining a total power difference between the second total electric power magnitude and the first total electric power magnitude. In this example the total power difference is 220 W.
a11) determining a local power magnitude being the total electric power dissipated in an area of the support plate covered by the substrate. It is for example determined that the local power magnitude is 195 W.
a12) computing a ratio between the total power difference and the local power magnitude. In this example, the ratio is 220W/195W and therewith is equal to 1.128.

In the power controlled functional mode b) the substrate is placed on the free surface of the support plate and an electric power with a respective fifth magnitude to each of the heating strips that has an area covered by the substrate. The respective fifth magnitude equals the product of the respective third magnitude and the above-mentioned ratio. An electric power with the respective third magnitude is provided to each of the heating strips that does not have an area covered by the substrate.

### BRIEF DESCRIPTION OF THE DRAWINGS

These and other aspects are described in more detail with reference to the drawings. Therein:
FIG. 1 is a cross-section that schematically shows an embodiment of the improved thermal processing device;
FIG. 2 and FIG. 3 shows aspects thereof in more detail, therein FIG. 2 is a planar view and FIG. 3 shows in A and B the cross-sections IIIA and IIB of FIG. 2 respectively;
FIG. 4 shows an exemplary power supply unit for use with an embodiment of the improved thermal processing device;
FIG. 5 is a cross-section that schematically shows a further embodiment of the improved thermal processing device;
FIG. 6 is a top view of an exemplary component of an embodiment of the improved thermal processing device;
FIG. 7 schematically illustrates an embodiment of an improved method of thermal processing structures on a substrate;
FIG. 8 shows an exemplary controller in an embodiment of the improved thermal processing device;
FIG. 9A and 9B show aspects related to temperature control in an embodiment of the improved method;
FIG. 10A, 10B and 10C show a calibration procedure;
FIG. 11A, 11B and 11C show aspects of a simulation.

### DETAILED DESCRIPTION OF EMBODIMENTS

Like reference symbols in the various drawings indicate like elements unless otherwise indicated.

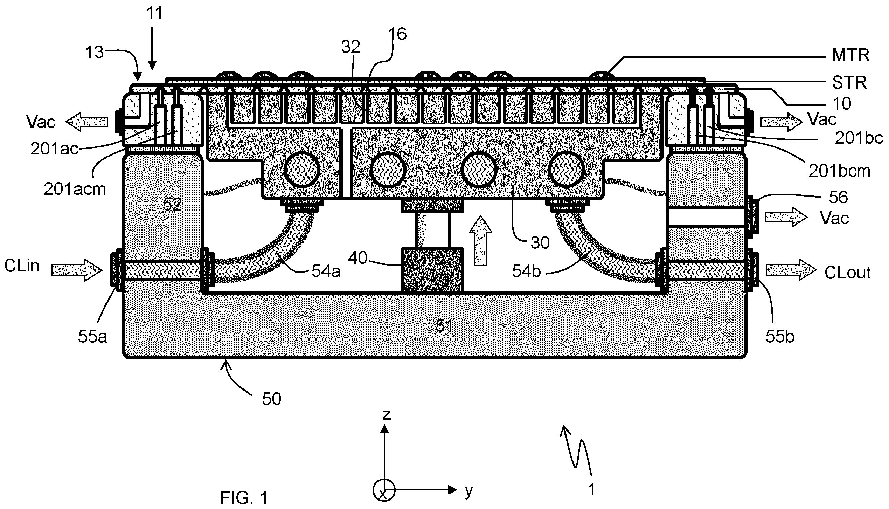

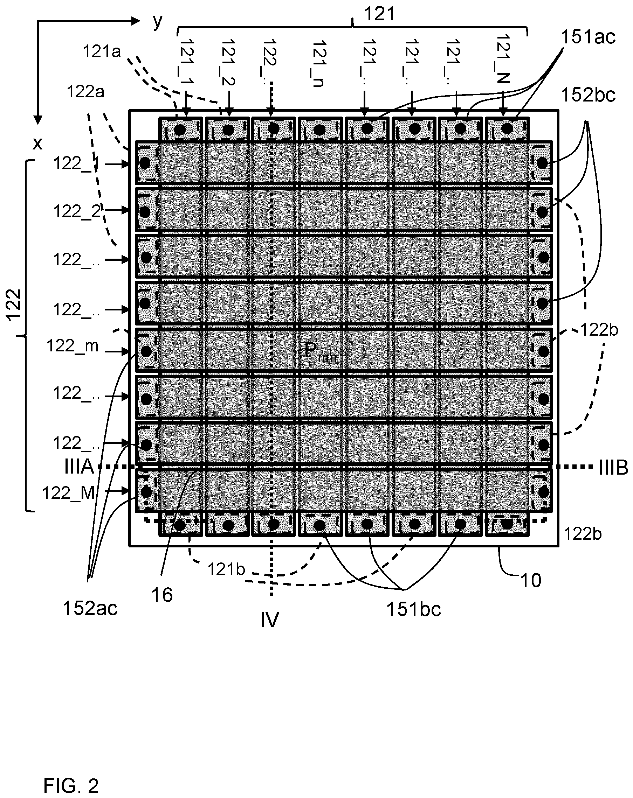

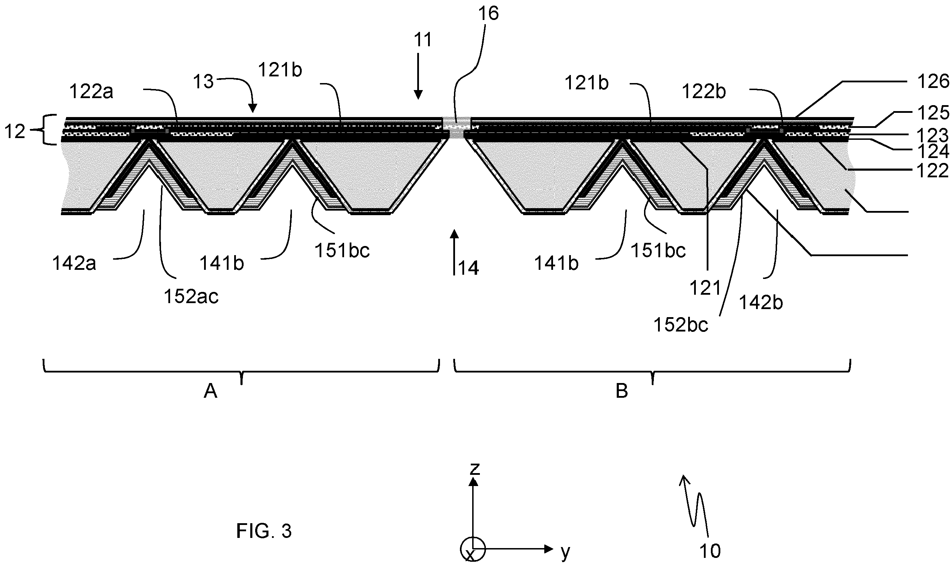

FIG. 1 is a cross-section that schematically shows an embodiment of the improved thermal processing device 1 for thermal processing material MTR on a substrate STR. FIG. 2 and FIG. 3 shows aspects thereof in more detail. Therein FIG. 2 is a planar view and FIG. 3 shows in A and B the cross-sections IIIA and IIB of FIG. 2 respectively.

The substrate STR can be any of a rigid substrate like glass or flexible substrate of a polymer, e.g. PET or PEN. The material MTR to be thermally processed can be an electrically insulating and thermally insulating material, an electrically insulating and thermally conductive material, an electrically conductive and thermally insulating material, and an electrically conductive and thermally conductive material. The material MTR, commonly also denoted as inks or pastes for example may comprise nanoparticle or micronparticles or a mix thereof suspended in a (high boiling point) solvent. Also epoxy based materials, such as adhesives or conductive adhesives with silver micron particles are used. Alternatively or additionally the substance may comprise one or more of a solder, a mixture of eutectic materials, positive or negative photoresist, a polymer solution, a molten polymer, a monomer or a silicone based material.

As shown in FIG. 1, the thermal processing device comprises a support plate 10. The support plate 10 is provided at a first main side 11 with a layer stack that has a free surface 13 for supporting the substrate. An example of the layer stack 12 is shown in more detail in FIG. 3.

The free surface 13 defines a reference plane x,y and as shown in FIG. 3, the layer stack 12 includes a first resistive heating layer 121, a second resistive heating layer 122, and an electrical insulator layer 123 between the first resistive heating layer 121 and said second resistive heating layer 122.

As can best be seen in FIG. 2, the first resistive heating layer 121 comprises a first plurality of mutually electrically insulated resistive heating strips 121_1, 121_2, ..., 121_n, ...,121_N that extend in a direction of a first axis x in the reference plane.

Likewise, the second resistive heating layer 122 comprises a second plurality of mutually electrically insulated resistive heating strips 122_1, 122_2, ..., 122_m, ...,122_M that extend in a direction of a second axis y in the reference plane differing from said first axis x.

Each of the resistive heating strips 121_1, 121_2, ..., 121_n, ...,121_N of the first plurality and each of the resistive heating strips 122_1, 122_2, ..., 122_m, ...,122_M of the second plurality is configured to be driven by a respective electric power source.

As shown in FIG. 2, this is the case in that the resistive heating strips of the first plurality each have a respective first end portion, 121a with a respective first electric contact 151ac and a respective second end portion 121b with a respective second electric contact 151bc opposite said first end portion, and likewise the resistive heating strips 122_1, 122_2, ..., 122_m, ..., 122_M of the second plurality each have a respective further first end portion 122a with a respective further first electric contact 152ac and a respective further second end portion 122b with a respective second further electric contact 152bc opposite said further first end portion.

In this embodiment, the support plate 10 comprises at a second main side 14, opposite the first main side 11 the following characteristics as shown in FIG. 3.

At each first end portion 121a and at each second end portion 121b of each heating strip 121_1,...,121_N of said first plurality the support plate 10 has a respective first recess and a respective second recess 141b that tapers inward in a direction towards a respective opening at the first main side 11 of the support plate 10. The respective first electric contact 151ac (FIG. 2, not shown in FIG. 3) at the respective first end 121a (FIG. 2, not shown in FIG. 3) and the respective second electric contact 151bc at the respective second end 121b is formed by a respective electrically conductive layer that is provided on the support plate 10 in the respective first recess and the respective second recess 141b. The respective first and second electric contacts are electrically connected respectively with the respective first end portion and the respective second end portion through the respective openings in the support plate 10.

Also, at each further first end portion 122a and at each further second end portion 122b of each heating strip 122_1,...,122_N of the second plurality a respective further first recess 142a and a respective further second recess 142b are present, that taper inward in a direction towards a respective opening at the first main side 11 of the support plate 10. The respective further first electric contact 152ac at the respective further first end 122a and the respective further second electric contact 152bc at the respective further second end 122b is formed by a respective electrically conductive layer that is provided on the support plate 10 in the respective first recess 142a and the respective second recess 142b and these further electric contacts are electrically connected respectively with the respective further first end portion and the respective further second end portion through said respective openings.

The layer stack 12 of the exemplary support plate shown in FIG. 3 comprises an additional electrical insulator layer 124 between its first main side 11 and the first resistive heating layer 121. Therewith it is not necessary that the support plate 10 itself is an electrical insulator. The support plate 10 is for a 1-0-0 oriented silicon wafer. This material is favorable in that it allows manufacturing of the support plate with a modest number of process steps. The additional electrical insulator layer 124 can be provided by oxidizing the surface of the silicon wafer.

As a further optional feature, the layer stack 12 as shown in FIG. 3 comprises an anti-stick layer 126 at a side facing away from the support plate 10. The presence of an anti-stick layer 126, such as a PTFE coating, a fluoropolymer coating, or a ceramic layer, e.g. of silicon dioxide, facilitates removal of a substrate in the inadvertent case that it melted during heating.

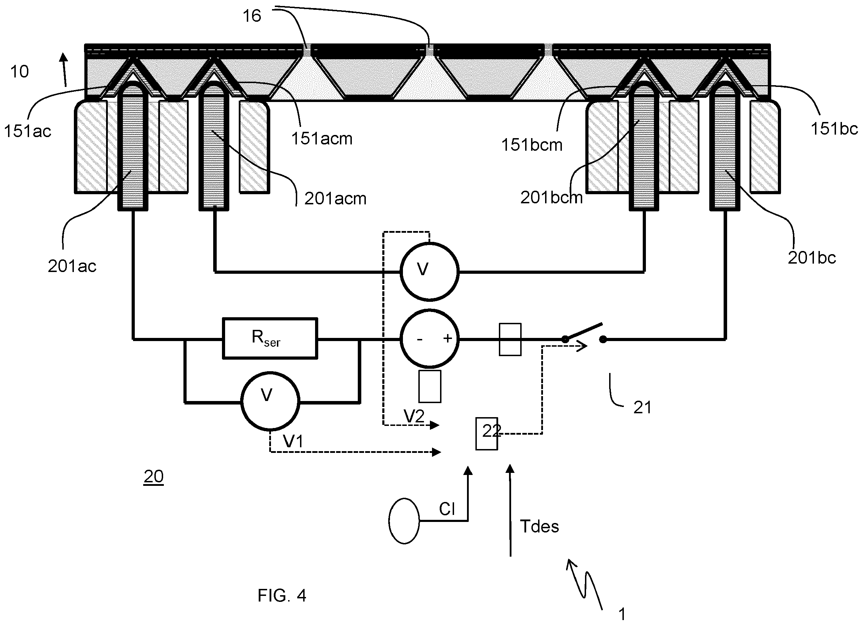

In an embodiment, the thermal processing device 1 further comprises a power supply with a respective power supply unit for each heating strip of the first plurality and for each heating strip of the second plurality. By way of example FIG. 4 shows the power supply unit 20 for one of the heating strips of the first plurality and its electrical connections to that heating strip, which is indicated in a cross-section according to IV in FIG. 2. As shown in FIG. 4, the first and second electric contacts 151ac, 151bc of the heating strip are electrically connected to contact elements 201ac, 201bc of the power supply unit 20. The power supply unit 20 comprises an electric power source section 21 and a power controller 22 to minimize a difference between an electric power provided by the respective power supply unit 20 and an electric power estimated to achieve a predetermined desired temperature value Tdes.

In the embodiment shown in FIG. 4, the power controller 22 comprises a temperature estimation section to provide an estimation of an operational temperature of the resistive heating strip to which it is connected and a feedback control section to minimize a difference between an operational temperature indicated by the estimation and a predetermined desired temperature value Tdes. The temperature estimation section is configured to measure an electrical resistance of the resistive heating strip and to compute an estimated value of the operational temperature on the basis of the measured electrical resistance and the temperature coefficient of resistance of the resistive heating strip. To that end the power controller 22 receives input signals about the delivered current and the voltage over the resistive heating strip. The delivered current is measured with a series resistance Rₛₑᵣ, arranged in series between the electric power source section 21 and the contacts 201ac, 201bc with which the resistive heating strip is connected. A voltage V1 over the series resistance Rₛₑᵣ, is measured. As shown in FIG. 4, in this case the power supply unit 20 has additional measurement contact elements 201acm, 201bcm that are respectively electrically connected first and second electric measurement contacts 151acm, 151bcm of the heating strip. A second voltage V2 is measured over these additional measurement contact elements 201acm, 201bcm. With the input signals indicative for the first and the second voltage V1, V2, the temperature estimation section of the power controller 22 is configured to estimate the current temperature of the heating strip based on a known relationship between the conductivity of the heating strip and its temperature, for example using a lookup table or a polynomial approximation.

In the embodiment shown, the feedback control section 22 comprises a PWM-controller. In a temperature controlled functional mode it provides a PWM-control signal to switch the electric power source section 21 such that the proper an amount of power is delivered that is estimated to achieve that the estimated current temperature that is estimated on the basis of the resistance of the heating strip is close to the desired temperature. In the embodiment shown the feedback control section 22 receives a clock signal, so that it is configured to periodically start a PWM-cycle in accordance with that clock signal. It ends each PWM-cycle when the estimated operational temperature of the heating strip tends to exceed the predetermined desired temperature value Tdes. An alternative embodiment is possible, wherein an external clock is absent, and wherein feedback control section 22 starts a PWM cycle upon detecting that the estimated operational temperature of the heating strip tends to fall below the predetermined desired temperature value Tdes with a predetermined amount or is already more than that predetermined amount below the predetermined desired temperature value Tdes. Conversely in that alternative embodiment, the feedback control section 22 ends a PWM cycle upon detecting that the estimated operational temperature of the heating strip tends to exceed the predetermined desired temperature value Tdes with a predetermined amount or is already more than that predetermined amount above the predetermined desired temperature value Tdes.

The thermal processing device may also be capable to operate in a power controlled operational mode. If for a particular substrate with material thereon the relationship between the operational temperatures of the heating strip and the supplied power is known for example from a calibration stage, or from a model calculation the thermal processing device can be operated in the power controlled operational mode to supply the required power that is expected to result in the desired operational temperatures. This is denoted as a feedforward control mode. In a variation the thermal processing device may also be capable to operate in a hybrid operational mode, wherein control is based on a combination of feedforward control based on an expected amount of power and feedback control based on sensed temperature data.

It is noted that a temperature distribution maybe estimated alternatively or additionally by separate temperature sensors, such as thermocouples and/or by an IR-camera that monitors a free surface of the substrate.

Typically the desired temperature Tdes of a heating strip is specified as a function of time as part of a thermal processing plan provided by the user that specifies a heating stage wherein the temperature is gradually increased, a curing stage, wherein the temperature is maintained at a predetermined level and a cooling stage wherein the temperature is lowered down so that a next deposition stage can be performed or in order that the substrate can be released for further processing steps on another device.

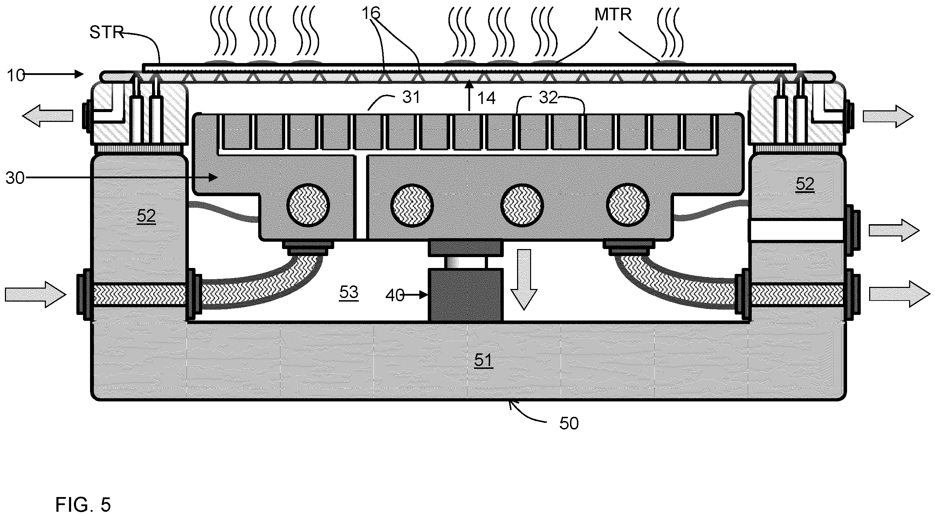

In an embodiment of the thermal processing device as shown in FIG. 1, a cooling unit 30 is provided that has a cooling surface 31 (See FIG. 5) at a side facing the second side 14 of the support plate 10. In this embodiment also an actuator 40 is provided that is configured to position the cooling unit 30 with its cooling surface 31 at a distance from the support plate 10 in a first functional mode, as shown in FIG. 5. Therein the power supply is activated to provide the controlled electric power to the heating strips. In a second operational mode, as shown in FIG. 1, the actuator 40 is configured to position the cooling unit 30 with its cooling surface in thermal contact with the support plate in order to rapidly cool down the support plate 10. As shown in FIG. 1, the cooling unit 30 is coupled with flexible tubes 54a, 54b to a cooling liquid inlet 55a and cooling liquid outlet 55b to provide for an active cooling with a flow of cooling liquid Clin, Clout.

In an embodiment, as illustrated in FIGs. 1 and 5 the thermal processing device 1 further comprises a housing 50 with a bottom wall 51 and a round going wall 52 extending from the bottom wall. The support plate 10 is carried by a side of the round going wall 52 opposite the bottom wall 51. The cooling unit 30 and the actuator 40 are arranged in a space 53 enclosed by the bottom wall 51, the round going wall 52 and the plate 10. As can be seen for example in FIG. 3 and FIG. 4, evacuation openings 16 extend through the support plate 10. The cooling unit 30 comprises respective evacuation channels 32 that extend from the cooling surface to communicate with the space enclosed by the housing. These evacuation channels 32 are arranged opposite respective evacuation openings 16 to allow application of a vacuum at the first main side 11 by communication with the enclosed space at the second main side which is through the evacuation openings 16 in the support plate and the evacuation channels 32. The enclosed space is evacuated through an opening 56 coupled to a vacuum pump (not shown). During the first operational mode as shown in FIG. 5, and the second operational mode as shown in FIG. 4 the vacuum applied at the evacuation openings 16 in the support plate 10 render it possible that the substrate STR with the material MTR deposited thereon is tightly pressed against the surface of the support plate 10 so that a good thermal contact is achieved therewith during heating as well as cooling.

As shown in FIG. 2 the evacuation openings 16 are provided at positions between a pair of subsequent resistive heating strips of said first plurality 121 and a pair of subsequent resistive heating strips of said second plurality 122.

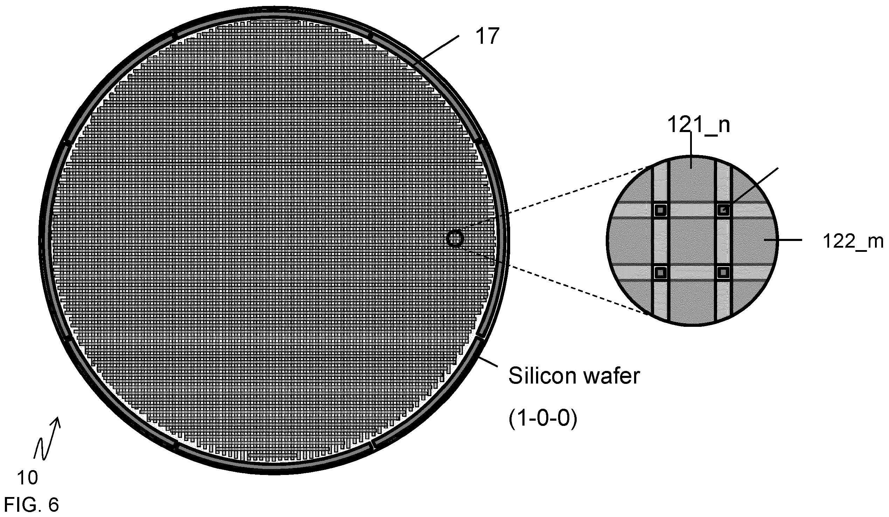

FIG. 6 shows in a top view of an example of the support plate 10 that at its periphery to be supported by the round going wall 52 of the housing 50 comprises one or more compensation heating strips 17. The compensation heating strips 17 serve to compensate for a flow of heat from the periphery of the support plate 10 to the round going wall 52. Therewith a more uniform temperature distribution over the surface of the support plate 10 is achieved.

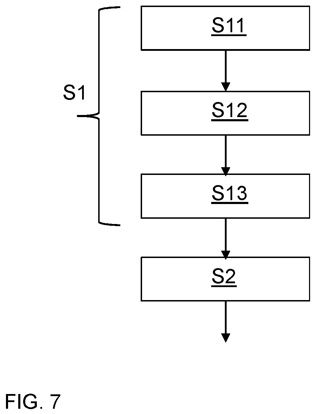

FIG. 7 schematically illustrates a method of thermal processing structures on a substrate.

The method shown therein comprises a step S1 of providing a support plate 10 at a first main side 11 with a layer stack 12 having a free surface 13 for supporting the substrate. The free surface defines a reference plane with a mutually orthogonal first axis x and second axis y. Providing the layer stack 12 includes the subsequent steps.

A first resistive heating layer 121 is provided in step S11 having a first plurality of mutually electrically insulated resistive heating strips 121_1, 121_2, ..., 121_n, ...,121_N extending in a direction of the first axis x in the reference plane,

An electrical insulator layer 123 is provided on the first resistive heating layer 121 in step S12,

A second resistive heating layer 122 is provided on the electrical insulator layer 123 in step S13. The second resistive heating layer 122 likewise has a second plurality of mutually electrically insulated resistive heating strips 122_1, 122_2, ..., 122_m, ...,122_M. These extend in a direction of the second axis y in the reference plane.

Subsequent to support plate 10 at a first main side 11 with a layer stack 12 a substrate with material to be cured is arranged on the free surface 13 of the layer stack, and a respective controlled electric power is supplied in step S2 to each of the resistive heating strips 121_1, 121_2, ..., 121_n, ...,121_N, 122_1, 122_2, ..., 122_m, ...,122_M of the first plurality and of the second plurality for heating the substrate with a controlled spatial distribution over the area of the free surface 13.

In an embodiment of the method a substantially uniform temperature distribution is achieved in that the power supplied to the heating strips is controlled mutually independently. I.e. for each heating strip a respective electric power source is provided to supply the proper amount of power to achieve a desired temperature of the heating strip and/or a desired temperature change as a function of time. It is noted that even in case that the temperature distribution is uniform, this does not necessary imply that the power delivered to each heating strip is the same. For example in case of a circular support plate 10, as shown in FIG. 6, the heating strips have mutually different length. To maintain a uniform temperature distribution the supplied power is to be approximately proportional to the length of the heating strips.

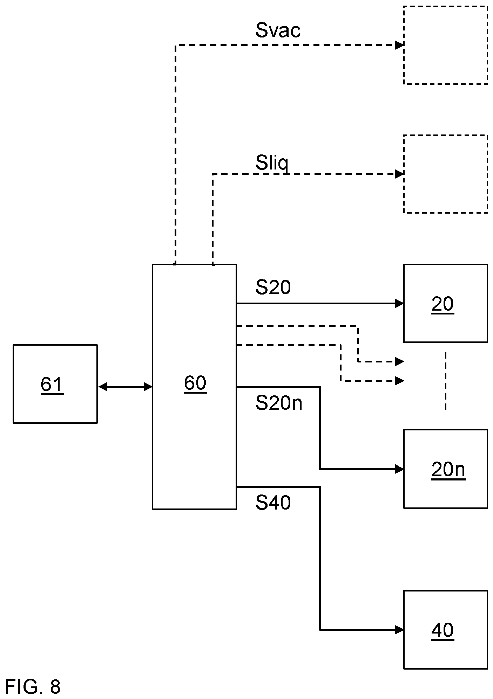

FIG. 8 shows a controller 60 in an embodiment of the improved thermal processing device that is configured to control operation of various device components. In the example shown, the controller 60 is configured to provide a respective control signal S20, .., S20n to each of the power supply units 20, ..., 20n. Each power supply unit 20, ..., 20n is configured to autonomously control the heating rate of its proper heating strip in accordance with the control signals S20, .., S20n provided by the controller 60. The controller 60 also controls the actuator 40 with an actuator control signal S40. Also the controller 60 may control a vacuum pump and/or a valve with which the vacuum pump is connected to the opening 56 with a control signal Svac. Further, the controller 60 may control a cooling liquid supply unit with a control signal Sliq. In the example of FIG. 8, the controller 60 is coupled to a user interface 61. Therewith an operator can specify a temperature profile with which thermal processing is to be performed as a function of time.

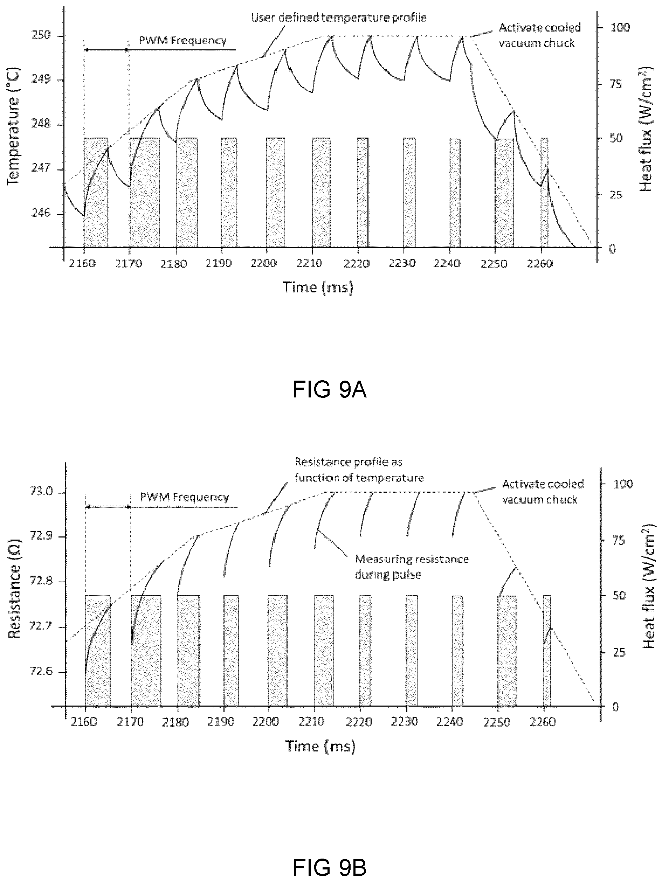

An exemplary operation is shown in FIG. 9A, 9B. Therein the temperature profile specified by the operator is shown as a dotted line. The temperature scale is indicated at the left side of the graph. The controller 60 provides each power supply unit 20, ..., 20n with a respective control signals S20, .., S20n instructing the power supply unit to supply the proper amount of power to the heating strip connected thereto so as to approximate the specified temperature profile. The power scale is indicated at the right side of the graph. FIG. 9A, 9B show how an exemplary power supply unit 20 as shown in FIG. 4 accordingly supplies a PWM controlled power to the heating strip connected thereto. As described above, the exemplary power supply unit 20 of FIG. 4 operates at a fixed frequency according to a clock signal Cl. Each PWM cycle is initiated by the clock signal Cl, and is ended when the respective temperature indicator of the each heating strip indicates that its estimated average temperature tends to exceed the predetermined desired temperature value Tdes as defined by the temperature profile as a function of time. In FIG. 9A, the solid curve indicates the actual temperature as a function of time. In the embodiment shown, the power supply unit 20 estimates the temperature of the resistive heating strip by measuring its resistance during the active stage of the PWM cycle. The estimated temperature during the active stage of the PWM cycle is indicated in FIG. 9B. As the power supply unit 20 ends the active stage of the PWM cycle when the temperature tends to exceed the desired temperature, and the resistive heating strip will cool down in the passive stage of the PWM cycle it is not necessary to know the temperature during the passive stage. I.e. for shorter strips the duty cycle will be relatively short as compared to longer strips.

Should it not be desired that the strips have approximately the same duty cycle, it is possible to replace short linear strips by meandering strips.

It is noted that as a result of the temperature based control automatically the proper amount of power is supplied to the each strip regardless its length.

As further shown in FIG. 9A, 9B, a forced cooling is applied subsequent to heating the substrate. This is achieved in that the controller 60 provides a control signal S40 to the actuator 40 that causes it to move the cooling unit 30 against the support plate 10. In the example shown the power supply units are maintained in an operational state, so that the temperature decreases at a lower rate (as prescribed by the user defined temperature profile) than would otherwise be the case if the temperature of the support plate 10 would only be determined by the thermal contact with the cooling unit 30.

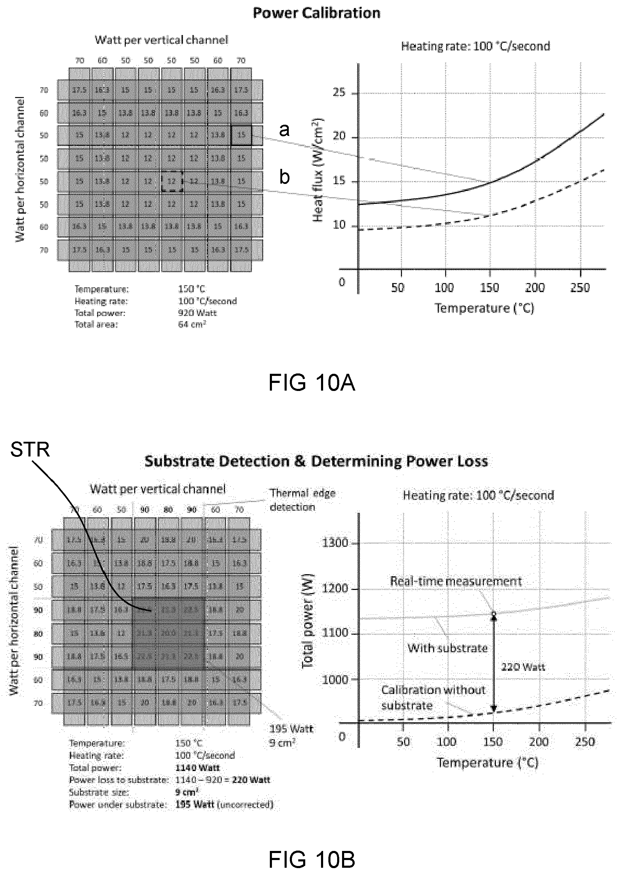

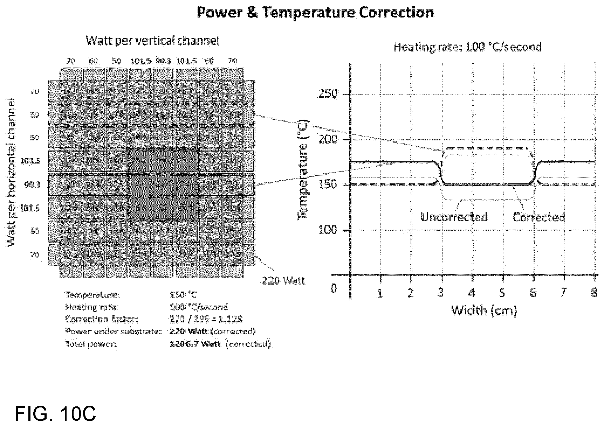

In case the substrate STR fully covers the support plate, it suffices that the heating strips each have the same temperature as a function of time. A different situation arises if the substrate only covers a portion of the support plate. In this case the temperature of the strip tend to be lower in the area where it is covered by the substrate than the remaining area where it is not covered. Also in this case a proper temperature distribution can be achieved provided that a calibration is performed. This procedure and the subsequent thermal processing of the substrate in accordance with the calibration is now described with reference to FIG. 10A, 10B and 10C.

As shown in FIG. 10A, a first calibration stage is performed in the absence of a substrate on the free surface. A respective controlled electric power is supplied to each heating strip to achieve that each of the respective temperature indicators of the resistive heating strips indicates at a point in time that a situation is achieved wherein the temperature has a predetermined value and increases with a predetermine rate.

By way of example, as shown in the right part of FIG. 10A, the predetermined temperature value is specified as 150 C and the predetermined temperature increasing rate is 100 C/s. By way of example the graph in the right part of FIG. 10A shows the measured relationship with which the heating rate of 100 C/s at a temperature of 150 C is achieved for a first area a at the periphery of the support plate and a second area b in the middle of the support plate.

Then a first magnitude is determined of the electric power supplied to each of the heating strips with which this situation is achieved. Also a second respective magnitude is determined of the electric power supplied by each respective pair of a resistive heating strips of the first plurality and a heating strip of the second plurality and that is dissipated in the area wherein a pair of heating strips overlap.

The left part of FIG. 10A shows the first magnitudes near the respective ends of each heating strip and shows the second magnitudes in each of the areas of overlap. As shown in FIG. 10A the first area a and the second area b respectively require a power of 15 W and 12 W to achieve the heating rate of 100 C/s at a temperature of 150 C.

Also a first total electric power magnitude being the sum of the first magnitudes is determined, which in this case is 920 W.

FIG. 10B shows a second stage of the calibration stage. Now the substrate STR is placed on the free surface of the layer stack. With the substrate STR placed on the free surface, the same measurements are performed as in the first stage.

A respective controlled electric power is supplied to each heating strip to achieve that each of the respective temperature indicators of the resistive heating strips indicates at a point in time that a situation is achieved wherein the temperature has the predetermined value (150 C in this example) and increases with a predetermine rate (100 C/s in this example).

The left side of FIG. 10B shows the third magnitudes of the electric power supplied to each of the heating strips with which this situation is achieved. Additionally the left side shows the fourth respective magnitude of the electric power supplied by each respective pair of a resistive heating strips 121_1, 121_2, ..., 121_n, ...,121_N of the first plurality and a heating strip 122_1, 122_2, ..., 122_m, ...,122_M of the second plurality.

A second total electric power magnitude is determined as the sum of the second magnitudes, in this example 1140 W.

Then a total power difference is determined between the second total electric power magnitude and the first total electric power magnitude, which in this example is 220 W.

Also local power magnitude is determined as the total electric power dissipated in an area of the support plate covered by the substrate, in this example 195 W.

Then a ratio is computed between the total power difference and the local power magnitude. In this example the ratio is equal to 1.128. As shown in FIG. 10C, during the processing stage the power to be supplied to the heating strips covered by the substrate is multiplied with this ratio to account for the effect of the presence of the substrate on the temperature-power dependency.

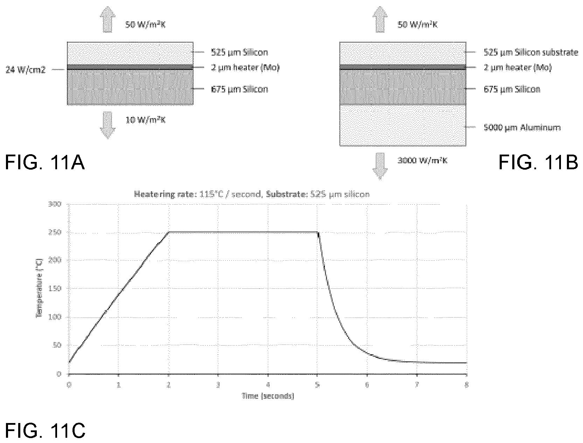

By way of example simulation results are shown in FIG. 11A - 11C. These simulations show that for a 675 µm thick silicon heater plate, only 14 W/cm2 is required to heat at a rate of 115 °C per second in the middle of the wafer. On the side, where the wafer is contacting the PTFE, the heat flux needs to be 19 W/cm2 in to reach the same heating rate. The total power for heating a 150 mm wafer would be around 2700 watts (1860 + 840). Heating to 250 °C would mean that 5400 Joule is required. For keeping the wafer at this temperature, much less power is needed. After heating, the entire wafer can be cooled down from 250 °C to room temperature in two seconds by activating the water cooled vacuum chuck. This enables drying and/or curing (soldering) possible within 10 seconds.

In case a substrate is placed on top of the wafer as shown in FIG. 11A, for example a 525 µm thick silicon wafer, a heat flux of 24 W/cm2 is required to achieve the same heating rate of 115 °C per second. FIG. 11C shows the simulation of the temperature as a function of time, wherein the substrate is heated at a rate of 115 °C per second during 2 seconds, is maintained at a temperature of 250 °C during 3 seconds and subsequently is cooled by thermal contact with a heatsink as shown in FIG. 11B. The effect of placing a smaller substrate on the heater can be compensated by a calibration and heat flux correction as determined with the method specified with reference to FIG. 10A - 10C.

Based on the measured thermal profile, it would also be possible to understand what kind of substrate is placed on the heater. For example heat capacity and thermal conductivity can be approximated/calculated. This additional information can be used to finetune the temperature profile on the top side of the substrate, especially for thick and low thermally conductive substrates.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. A thermal processing device (1) for thermal processing material (MTR) on a substrate (STR), the thermal processing device comprising a support plate (10) which at a first main side (11) is provided with a layer stack (12) having a free surface (13) for supporting the substrate, wherein the free surface defines a reference plane (x,y) and which layer stack (12) includes (See FIG. 2):
a first resistive heating layer (121),
a second resistive heating layer (122), and
an electrical insulator layer (123) between said first resistive heating layer (121) and said second resistive heating layer (122),
wherein the first resistive heating layer (121) comprises a first plurality of mutually electrically insulated resistive heating strips (121_1, 121_2, ..., 121_n, ...,121_N) extending in a direction of a first axis (x) in the reference plane,
wherein the second resistive heating layer (122) comprises a second plurality of mutually electrically insulated resistive heating strips (122_1, 122_2, ..., 122_m, ...,122_M) extending in a direction of a second axis (y) in the reference plane differing from said first axis, and
wherein each of the resistive heating strips (121_1, 121_2, ..., 121_n, ...,121_N) of the first plurality and each of the resistive heating strips (122_1, 122_2, ..., 122_m, ...,122_M) of the second plurality is configured to be driven by a respective electric power source.

2. The thermal processing device (1) according to claim 1, wherein the resistive heating strips (121_1, 121_2, ..., 121_n, ...,121_N) of the first plurality each have a respective first end portion (121a) with a respective first electric contact (151ac) and a respective second end portion (121b) with a respective second electric contact (151bc) opposite said first end portion, and wherein the resistive heating strips (122_1, 122_2, ..., 122_m, ...,122_M) of the second plurality each have a respective further first end portion (122a) with a respective further first electric contact (152ac) and a respective further second end portion (122b) with a respective second further electric contact (152bc) opposite said further first end portion.

3. The thermal processing device (1) according to claim 2, wherein the support plate (10) at a second main side (14), opposite the first main side (11) comprises:
at each first end portion (121a) and at each second end portion (121b) of each heating strip (121_1,...,121_N) of said first plurality a respective first recess and a respective second recess (141b) that tapers inward in a direction towards a respective opening at the first main side (11) of the support plate (10), and wherein the respective first electric contact (151ac) at the respective first end (121a) and the respective second electric contact (151bc) at the respective second end (121b) is formed by a respective electrically conductive layer that is provided on the support plate (10) in said respective first recess and said respective second recess (141b) and that is electrically connected respectively with the respective first end portion and the respective second end portion through said respective openings,
at each further first end portion (122a) and at each further second end portion (122b) of each heating strip (122_1,...,122_N) of said second plurality a respective further first recess (142a) and a respective further second recess (142b) that tapers inward in a direction towards a respective opening at the first main side (11) of the support plate (10), and wherein the respective further first electric contact (152ac) at the respective further first end (122a) and the respective further second electric contact (152bc) at the respective further second end (122b) is formed by a respective electrically conductive layer that is provided on the support plate (10) in said respective first recess (142a) and said respective second recess (142b) and that is electrically connected respectively with the respective further first end portion and the respective further second end portion through said respective openings.

4. The thermal processing device (1) according to claim 1, wherein each of the resistive heating strips (121_1, 121_2, ..., 121_n, ...,121_N) of the first plurality and each of the resistive heating strips (122_1, 122_2, ..., 122_m, ...,122_M) of the second plurality has a respective first and a respective second electric contact extending laterally from its respective first and its respective second end portion.

5. The thermal processing device (1) according to claim 1, further comprising a power supply with a respective power supply unit (20), for each heating strip of the first plurality and for each heating strip of the second plurality, comprising an electric power source section (21) and a power controller (22) to minimize a difference between an electric power provided by the respective power supply unit (20) and an electric power estimated to achieve a predetermined desired temperature value (Tdes).

6. The thermal processing device (1) according to claim 5, which power controller (22) comprises a temperature estimation section to provide an estimation of an operational temperature of a resistive heating strip and a feedback control section to minimize a difference between an operational temperature indicated by the estimation and a predetermined desired temperature value (Tdes).

7. The thermal processing device (1) according to claim 5, wherein the temperature estimation section is configured to measure an electrical resistance of the resistive heating strip and computes an estimated value of the operational temperature on the basis of the measured electrical resistance and the temperature coefficient of resistance of the resistive heating strip.

8. The thermal processing device (1) according to claim 5 or 6, being operable in an operational mode selected from a calibration mode and a power controlled functional mode, which thermal processing device when operable in the calibration mode is configured to perform a calibration wherein it estimates a relationship between a supplied electric power by each of the power supply units (20) as a function of time and a temperature distribution as a function of time, and which thermal processing device when operable in the power controlled functional mode controls an electric power supplied by each of the power supply units (20) as a function of time to approximate a desired temperature distribution as a function of time based on the estimated relationship.

9. The thermal processing device (1) according to claim 6, 7 or 8, being operable in an operational mode selected from at least a temperature controlled functional mode, which thermal processing device when operable in the temperature controlled functional mode controls a supplied power to each resistive heating strip to minimize a difference between an operational temperature of said each heating strip indicated by the estimation and a predetermined desired temperature value (Tdes) as a function of time.

10. The thermal processing device (1) according to claim 9, wherein the feedback control section (22) comprises a PWM-controller provide a PWM-control signal to switch the electric power source section (21) in the temperature controlled functional mode which PWM-controller is configured to periodically start a PWM-cycle in accordance with a clock signal and to end each PWM-cycle each time that the operational temperature of said each heating strip indicated by the estimation tends to exceed the predetermined desired temperature value (Tdes).

11. The thermal processing device (1) according to any of the preceding claims, further comprising a cooling unit (30) and an actuator (40), wherein the cooling unit (30) has a cooling surface (31) at a side facing the second side (14) of the support plate (10), and wherein the actuator (40) is configured to position the cooling unit (30) with its cooling surface (31) at a distance from the support plate in a first functional mode wherein the power supply is activated to provide the controlled electric power and wherein the actuator is configured to position the cooling unit (30) with its cooling surface in thermal contact with the support plate in a second functional mode in order to rapidly cool down the plate.

12. The thermal processing device (1) according to claim 11, further comprising a housing (50) with a bottom wall (51) and a round going wall (52) extending from the bottom wall, wherein the support plate (10) is carried by a side of the round going wall opposite the bottom wall, and wherein the cooling unit (30) and the actuator (40) are arranged in a space (53) enclosed by the bottom wall, the round going wall and the plate to be evacuated in operation, wherein evacuation openings (16) extend through the support plate and wherein respective evacuation channels (32) extending through the cooling unit (30) from the cooling surface to communicate with the space enclosed in the housing, which respective evacuation channels are arranged opposite said evacuation openings to allow application of a vacuum at the first main side (11) by communication with the enclosed space at the second main side through the evacuation openings (16) in the support plate and the evacuation channels (32) wherein in the cooling unit (30).

13. The thermal processing device (1) according to claim 12, wherein the evacuation openings (16) are provided at positions between a pair of subsequent resistive heating strips of said first plurality and a pair of subsequent resistive heating strips of said second plurality.

14. The thermal processing device (1) according to claim 12 or 13, wherein the support plate (10) at a periphery supported by the round going wall (52) of the housing (50) comprises one or more compensation heating strips (17).

15. A method of thermally processing structures on a substrate comprising:
- providing a support plate (10) at a first main side (11) with a layer stack (12) having a free surface (13) for supporting the substrate, wherein the free surface defines a reference plane (x,y), wherein providing the layer stack (12) includes the subsequent steps:
providing a first resistive heating layer (121) having a first plurality of mutually electrically insulated resistive heating strips (121_1, 121_2, ..., 121_n, ...,121_N) extending in a direction of a first axis (x) in the reference plane,
providing an electrical insulator layer (123),
providing a second resistive heating layer (122) having a second plurality of mutually electrically insulated resistive heating strips (122_1, 122_2, ..., 122_m, ...,122_M) extending in a direction of a second axis (y) in the reference plane differing from said first axis,
supplying a respective controlled electric power to each of the resistive heating strips (121_1, 121_2, ..., 121_n, ...,121_N, 122_1, 122_2, ..., 122_m, ...,122_M) of the first plurality and of the second plurality for heating the substrate with a controlled spatial distribution over the area of the free surface (13).
